# EUROPÄISCHE PATENTSCHRIFT

(11) **EP 1 905 868 B1**
(45) Veröffentlichungstag und Bekanntmachung des Hinweises auf die Patenterteilung: **07.11.2012**
(21) Anmeldenummer: 07116016.2
(22) Anmeldetag: 10.09.2007
(51) Int. Cl.: C23C 16/02, C23C 16/04, C23C 16/26, B41N 7/00

(54) **Verfahren zur Herstellung einer anti-adhäsiven und verschleißbeständigen Oberfläche**
Method for manufacturing an anti-adhesive and wear-resistant surface
Procédé destinés à la fabrication d'une surface anti-adhésive et résistant à l'usure

(30) Priorität: 29.09.2006 DE 102006046524
(43) Veröffentlichungstag der Anmeldung: 02.04.2008
(73) Patentinhaber: Koenig & Bauer Aktiengesellschaft, 97080 Würzburg (DE)
(72) Erfinder: Patzelt, Bernd, 09126, Chemnitz (DE); Dr. Hopfe, Volkmar, 01814, Kleingießhübel (DE); Dr. Dani, Ines, 09244, Lichtenau (DE); Koch, Michael, 01156, Dresden-Cossebaude (DE); Linaschke, Dorit, 01217, Dresden (DE)

(56) Entgegenhaltungen:
- EP-A- 0 395 198
- US-A- 4 960 050
- US-A- 5 529 815

## Beschreibung

Die Erfindung betrifft ein Verfahren zur Herstellung einer anti-adhäsiven und verschleißbeständigen Oberfläche auf Rotationskörpern oder deren Mantelflächenelementen, die insbesondere für den Einsatz in Papiermaschinen oder Rotationsdruckmaschinen vorgesehen sind.

In der Papier- und Druckindustrie steht der Bedruckstoff während seiner Herstellung oder während seines Bedruckens häufig in abrasivem Kontakt mit Leiteinrichtungen und rotierenden Trommeln und Zylindern, wobei in unerwünschter Weise Bedruckstoffkomponenten oder Druckfarbe auf die kontaktierenden Oberflächen übertragen werden und zu Qualitätsbeeinträchtigungen bis hin zu Prozessstörungen führen. Abhilfe können verschleißbeständige Beschichtungen der Kontaktflächen mit Antihafteigenschaften insbesondere gegenüber Farbe schaffen.

In Bogendruckmaschinen für zweiseitiges Bedrucken kommen insbesondere in der Druckzone zwischen Gummituchzylinder und Gegendruckzylinder frisch bedruckte Bogenunterseiten durch das Überwalzen der Bogen beim Aufbringen des Widerdruckes mit der Oberfläche des bogenführenden Gegendruckzylinders in Kontakt, wobei Farbe auf die Oberfläche übertragen wird und/ oder das Druckbild abschmiert.

Die abgelegte Farbe sammelt sich auf der Gegendruckzylinderoberfläche, bis es zu einer fehlerhaften Rückübertragung kommt. Die Folge ist Mottling, so dass die Produktion unterbrochen werden muss, um die Oberflächen zu reinigen. Im Extremfall kann es dazu kommen, dass anspruchsvolle Druckaufträge nicht verarbeitet werden können.

Um die unerwünschte Farbübertragung auf Druckmaschinenzylinder oder-trommeln zu minimieren, werden die Kontaktflächen mit Raustrukturen einer Chrom enthaltenden Beschichtung ausgestattet, die die farbübertragende Kontaktfläche auf Tragpunkte reduzieren, aber einen erhöhten Reinigungsaufwand, d.h. kürzere Waschzyklen, erfordern. Weiterhin ist es bekannt, rau strukturierte Flächen mit farbabweisenden und/oder leicht reinigbaren Beschichtungen zu versehen.

Derartige Antihaftschichten, die beispielsweise mittels Nanosoltechnologie durch Tauchen oder Spritzen aufgebracht werden, enthalten fluor- und/oder silikonhaltige Substanzen, teilweise mit Zusatz von Füllstoffen.

Diese Beschichtungen müssen aber nach dem Auftragen auf die Oberfläche zur Verfestigung anschließend getempert werden, wodurch die Formhaltigkeit der beschichteten Körper beeinträchtigt wird. Außerdem ist die Verschleißfestigkeit solcher Schichten häufig nicht ausreichend, um über längere Zeiträume die Antihafteigenschaften solcher Oberflächen aufrecht zu erhalten.

DLC- basierte Schichten, die Verschleißbeständigkeit und Antiadhäsionseigenschaften kombinieren (z.B. SICON- Patent EP 1062088) sind wiederum nur mit aufwändigen Vakuumverfahren herstellbar, so dass größere Maschinenteile nicht mit DLC beschichtet werden können.

Um schnell verschleißende Antihaftschichten dennoch auf Zylinderoberflächen einsetzen zu können, werden diese auf Zwischenträgern, sogenannten Mantelblechen oder Jackets, appliziert, die über die Oberfläche des massiven Zylinders gespannt werden und dann nach Bedarf bzw. Verschleiß gegen neue Mantelbleche getauscht werden können, wenn die Antihaftschicht verschlissen ist. Schwierig ist hier die Formhaltung der Mantelbleche, die ihre Dickentoleranz zu der Durchmessertoleranz des darunter liegenden Druckzylinder addieren und so in jedem Fall den für ein hochwertiges Druckergebnis wichtigen Rundlauf der Druckzylinderoberfläche verschlechtern. Außerdem können die dünnen Bleche nicht auf Zylindern eingesetzt werden, die im Wirkungsbereich von Trocknern installiert sind, weil der Temperatureintrag zu Verwerfungen der Mantelbleche führen würde.

Um die Schwierigkeiten mit einem Mantelblech als Zwischenträger einer Antihaftbeschichtung zu vermeiden, ist es bekannt, auf die Raustruktur der Oberfläche eine anti-adhäsive verschleißfeste Hartstoffschicht aufzubringen, deren Standzeit der Lebensdauer des beschichteten Druckmaschinenteils nahe kommt. Hierzu werden PVD- oder CVD-Verfahren benutzt. Ein wesentlicher Nachteil dieser Verfahren ist es, dass sie infolge der Bindung an Vakuumkammern für den großtechnischen Einsatz in der Serienproduktion, beispielsweise für die Beschichtung von groß dimensionierten Teilen wie Gegendruckzylinder, nicht geeignet sind.

Der Erfindung liegt daher die Aufgabe zugrunde, eine Lösung für eine großflächige, farbabweisende, leicht zu reinigende und verschleißfeste Antihaftschicht insbesondere auf der Raustruktur einer Gegendruckzylinderoberfläche zu schaffen, die ohne Beeinträchtigung der Rundlaufeigenschaften aufbringbar ist und wirtschaftlich in die Serienproduktion implementierbar ist.

Erfindungsgemäß wird die Aufgabe durch ein Verfahren mit den Merkmalen des ersten Anspruchs gelöst.

Das Wesen der Erfindung liegt in dem Einsatz einer neuen farbabweisenden und verschleißfesten Beschichtung auf der Raustruktur der Druckzylinder unter Anwendung einer modifizierten PACVD- Beschichtungstechnologie unter atmosphärischen Bedingungen, die die traditionellen PVD/CVD-Verfahren hinsichtlich des technischen Aufwandes um den Faktor 3 und in der Stückzeit um den Faktor 10 übertrifft.

Die Erfindung hat den Vorteil, dass mit einem industriell auch für Großteile anwendbaren Verfahren eine Kohlenstoffbeschichtung erzeugt wird, die anti-adhäsive und Verschleißschutzeigenschaften kombiniert und deren Standzeit der Zylinderlebensdauer entspricht. Die erfindungsgemäße Beschichtung weist eine mit Teflon vergleichbare geringe Oberflächenenergie auf.

Da die Beschichtung großflächig erfolgen kann, sind keine Jackets notwendig, wodurch die Rundlaufgüte des Zylinders erhalten werden kann.

Die Beschichtung ist langzeitstabil und aufgrund der Beständigkeit gegenüber

UV-Bestrahlung auch im Bereich von UV- Zwischentrocknern einsetzbar.

Das erfindungsgemäße Verfahren zur Aufbringung der Beschichtung auf Zylinderoberflächen oder deren Mantelflächenelemente soll nachstehend näher erläutert werden.

Das Verfahren und die Vorrichtung basieren auf der plasmagestützten chemischen Gasphasenabscheidung bei Atmosphärendruck, wobei die Beschichtungskomponenten aus einem Plasma, das unter Umgebungsbedingungen in einer mobilen Reaktionskammer aufrechterhalten wird, auf der raustrukturierten Oberfläche abgeschieden werden. Das grundsätzliche Verfahren und ein dazu geeigneter Reaktorkopf für eine großflächige Plasma-Prozessierung bei Atmosphärendruck sind in den Patentanmeldungen DE 102 39 875 A1, EP1 394 283 A1 und DE 10 2004 015 216 A1 beschrieben, wobei zur Plasmaerzeugung z.B. linear ausgedehnte DC-Plasmabogen (EP 0851720 A1) oder Mikrowellenplasma (DE19608949 A1, DE 10 2004 060 068 A1) genutzt werden.

Bei dem mit PACVD bezeichneten Verfahren zur großflächigen Beschichtung von Substraten bei Atmosphärendruckbedingungen wird in eine Plasmaquelle ein erster Gasstrom geführt, der Plasma aus einem großvolumigen Plasma aus der Plasmaquelle austreibt und das erzeugte Plasma durch mindestens eine Düse oder eine Mehrzahl von Düsen mit anderen Querschnittsgeometrien auf eine zu beschichtende Oberfläche des Substrates, die innerhalb einer abgedichteten Reaktionskammer angeordnet ist, richtet. Die Schichtausbildung erfolgt unmittelbar auf der Oberfläche des Substrates durch physiko-chemische Reaktion mindestens einer Komponente eines Precursors als Bestandteil mindestens eines zweiten Gasstromes, der in die Reaktionskammer und in den Einflussbereich des aus der einen oder mehreren Düsen austretenden Plasmas gerichtet wird. Durch Einstellung der Volumenströme, der Strömungsgeschwindigkeiten und/oder der Strömungsrichtungen des Plasmas und des zweiten Gasstromes sowie des Abstandes der Düsenöffnung (en) für das Plasma und Aufrechterhaltung eines vorgebbaren Innendrucks in der Reaktionskammer mittels einer Abgasabsaugung wird die physiko-chemische Reaktion zur Ausbildung der Beschichtung unmittelbar an der Oberfläche des Substrates beeinflusst.

Die im zweiten Gasstrom oder weiteren Gasströmen zugeführten schichtbildenden Precursoren werden durch Einwirkung des angeregten Plasmagases auf das im Beschichtungskopf zugegebene Precursor-Gasgemisch in aktive Radikale aufgespaltet.

Die erzeugten Radikale und/oder die in der Gasphase daraus gebildeten Verbindungen oder Cluster schlagen sich auf der Substratoberfläche nieder und bilden die anti-adhäsive verschleißbeständige Beschichtung, die sich in einer annähernd konstanten Schichtdicke konformal auf der Substratstruktur ausbildet.

Als Precursoren werden Kohlenwasserstoffverbindungen, siliciumorganische Verbindungen zur Ausbildung von Si-O-Schichtkomponenten und fluorhaltige Precursoren der Reaktionskammer zugeführt.

Das erfindungsgemäße Verfahren läuft in folgenden Schritten ab:
- Erzeugung einer haftungsreduzierenden Raustruktur auf der Oberfläche des Zylinders oder dessen Mantelflächenelementen,
- Auftragen einer amorphen Kohlenstoff- Beschichtung mittels des vorstehend beschriebenen PACVD- Verfahrens,
wobei
- in einer ersten Stufe unter Verwendung von kohlenwasserstoff- und siliziumhaltigen Precursoren ein C-H-Si-O- Grundgitter gebildet wird und
- in einer zweiten Stufe Fluor aus einem Fluor-Precursor eingebaut wird, so dass die Beschichtung C-H-Si-O-F in verschiedenen Zusammensetzungen aufweist.
Amorphe Kohlenstoffschichten bestehen aus einer hoch vernetzten Kohlenstoffmatrix mit einem hohen dreidimensionalen Bindungsanteil. Bei typischen Schichtdicken von 1 µm bis 10 µm besitzen diese Schichtsysteme Härten von 1000 HV bis 6000 HV. Zusätzlich verfügen die Schichten über einen geringen E- Modul, so dass die hohe Härte mit einer überdurchschnittlich hohen Elastizität verbunden ist. Für die vorliegende Anwendung ist der niedrige Reibbeiwert und die hohe Abrasivverschleißbeständigkeit entscheidend.

Durch den Einbau von Fluor in die Kohlenstoffschicht bildet sich eine PTFE(Teflon)- ähnliches Schichtsystem mit geringer Oberflächenenergie und dementsprechend stark hydrophoben und oleophoben Eigenschaften heraus. Die Modifizierung der Kohlenstoffschicht mit Silizium unterstützt die anti-adhäsiven Schichteigenschaften und fördert die Härte und

Verschleißfestigkeit von amorphen Kohlenstoffschichten.

Alternativ kann vorgesehen sein, die Beschichtung in einem einstufigen Prozess aufzubauen, indem ein Fluor- Precursor gemeinsam mit kohlenwasserstoff- und siliziumhaltigen Precursoren kontinuierlich oder mit wechselndem Volumenstrom zugeführt wird.

Durch einen Mehr- bzw. Multilagenaufbau der Beschichtung mit unterschiedlichen Fluoranteilen nimmt der Schichtverschleiß und der Reibwert weiter ab, ohne dass sich die Oberflächenenergie wesentlich ändert.

In einer vorteilhaften Weiterbildung des Verfahrens werden die am Reaktorkopf abgesaugten Abgase nachbehandelt, um potentiell umweltschädigende oder giftige Gasen in umweltneutrale Stoffe umzuwandeln.

Zur Beschichtung des rauhstrukturierten Gegendruckzylinders oder der Mantelfläche eines anderen bedruckstofführenden Rotationskörpers, beispielsweise einer Übergabetrommel traversiert der Reaktorkopf, welcher mit der zu beschichtenden raustrukturierten Oberfläche eine Reaktionskammer einschließt, der ein PACVD- Plasmastrom und in weiteren Gasströmen Precursoren und Spülgase zuführbar ist, berührungsfrei über dem rotierenden Rotationskörper oder Mantelflächenelement. Der Reaktorkopf kann beispielsweise an einer substratbreiten Traverse verfahrbar angeordnet sein, während das vorher raustrukturierte Gegendruckzylinder- Substrat darunter auf einem Wagen drehbar gelagert ist. Der Drehantrieb des Gegendruckzylinders und der Vorschub des Reaktorkopfes sind miteinander synchronisiert, so dass die Beschichtung mit konstanter Dicke erfolgen kann.

Der Reaktorkopf verfügt über einen Dichtspalt, der über die Spülgase sowohl das Eindringen der Umgebungsluft in den Reaktorkopf als auch ein Austreten der reaktiven Gase an die Umgebung verhindert. Der Dichtspalt des Reaktorkopfes bildet im Wesentlichen die Kontur des Rotationskörpers oder dessen Mantelflächenelementes nach.

Während sich die gleichmäßig gekrümmte Substratoberfläche seitlich translatorisch und in Umfangsrichtung rotativ durch die Reaktionskammer bewegt, wird die Reaktionskammer durch Zufuhr eines Spülgases in der Reaktionskammerrandzone mit einem Atmosphärendruckschleusensystem am Ein- und Austritt für das Substrat gegen die Umgebung abgedichtet. Eine Abgasabsaugung umschließt die Reaktionskammer allseitig.

Der Vorteil des PACVD-Verfahrens liegt in der niedrigen Abscheidetemperatur. Kohlenstoffschichten werden bereits bei Temperaturen unter 200°C abgeschieden, so dass auch temperaturempfindliche Werkstoffe oder Konstruktionen beschichtet werden können, ohne dass Formabweichungen eintreten. Die Temperaturbeständigkeit von Kohlenstoffschichten liegt bei etwa 350°C und wird durch den Einbau von Silizium in das Kohlenstoffnetzwerk bis auf etwa 500°C gesteigert, so dass der Einsatz im Wirkungsbereich von Trocknern möglich ist.

## Patentansprüche

1. Verfahren zur Herstellung einer anti-adhäsiven und verschleißbeständigen Oberfläche auf Rotationskörpern oder deren Mantelflächenelementen, die insbesondere für den Einsatz in Papier- oder Rotationsdruckmaschinen vorgesehen sind, mit folgenden Schritten:
- Erzeugung einer haftungsreduzierenden Raustruktur auf der Oberfläche mit bekannten Verfahren, wobei die Kontaktfläche auf Tragpunkte reduziert wird,
- Auftragen einer die Raustruktur konformal beschichtenden, amorphen und oleophoben Kohlenstoff- Beschichtung mittels PACVD- Verfahren,
wobei
- in einer ersten Stufe unter Verwendung von kohlenwasserstoff- und siliziumhaltigen Precursoren ein C-H-Si-O- Grundgitter gebildet wird und **gekennzeichnet dadurch, dass**
- in einer zweiten Stufe Fluor aus einem mit wechselndem Volumenstrom zugeführten Fluor-Precursor eingebaut wird,
so dass die Beschichtung die Elemente C, H, Si, O und F in verschiedenen Zusammensetzungen mit unterschiedlichen Fluoranteilen aufweist.

2. Verfahren nach Anspruch 1, wobei die Beschichtung in einem 1-Stufen-Prozess aufgebaut wird.

## Claims

1. Method of producing an anti-adhesion and wear-resistant surface on rotational bodies or the casing surface elements thereof, which are provided particularly for use in paper or rotary printing machines, comprising the following steps:
- producing an adhesion-reducing rough structure on the surface by known methods, wherein the contact surface is reduced to support points,
- applying an amorphous and oleophobic carbon coating, which conformally coats the rough structure, by means of a PACVD process, wherein
- in a first step with use of precursors containing hydrocarbon and silicon a C-H-Si-O base grid is formed,
**characterised in that**
- in a second step fluorine from a fluorine precursor supplied with a changing volume flow is incorporated so that the coating has the elements C, H, Si, O and F in different compositions with different fluorine proportions.

2. Method according to claim 1, wherein the coating is built up in a single-stage process.

## Revendications

1. Procédé d'obtention d'une surface anti-adhésive et résistant à l'usure sur des corps de révolution où leurs éléments de surfaces enveloppes destinés en particulier à être utilisés dans des machines d'impression de papier ou des machines d'impression rotatives comportant les étapes consistant à :
- produire une structure rugueuse de réduction de l'adhérence sur la surface avec des procédés connus, la surface de contact étant réduit à des points supports,
- appliquer un revêtement en carbone amorphe et oléophobe recouvrant la conformation de la structure rugueuse par le procédé PACVD, procédé selon lequel
- dans une première étape on forme un réseau de base C-H-Si-O en utilisant des précurseurs renfermant des hydrocarbures et du silicium, et
**caractérisé en ce que**
- dans une seconde étape, on incorpore du fluor à partir d'un précurseur de fluor fourni avec un flux volumique alternatif,
de sorte que le revêtement renferme les éléments C, H, Si, O et F dans des compositions différentes avec des proportions de fluor différentes.

2. Procédé conforme à la revendication 1,
**caractérisé en ce que**
le revêtement est obtenu selon un procédé à une seule étape.
